(19) Europäisches Patentamt
European Patent Office
Office européen des brevets

(11) **EP 1 306 942 A1**

(12) **DEMANDE DE BREVET EUROPEEN**

(43) Date de publication:
**02.05.2003 Bulletin 2003/18**

(51) Int Cl.⁷: **H01S 5/14**, H01S 5/125,
H01S 5/0625, H01S 5/065

(21) Numéro de dépôt: **02292524.2**

(22) Date de dépôt: **14.10.2002**

(84) Etats contractants désignés:
**AT BE BG CH CY CZ DE DK EE ES FI FR GB GR
IE IT LI LU MC NL PT SE SK TR**
Etats d'extension désignés:
**AL LT LV MK RO SI**

(30) Priorité: **15.10.2001 FR 0113260**

(71) Demandeur: **ALCATEL
75008 Paris (FR)**

(72) Inventeurs:
• **Duan, Guang-Hua
92290 Chatenay Malabry (FR)**
• **Jacquet, Joel
91470 Limours (FR)**

(74) Mandataire: **Fournier, Michel
Compagnie Financière Alcatel,
Intellectual Property Department,
5, rue Noel Pons
92734 Nanterre Cedex (FR)**

(54) **Générateur de brèves impulsions optiques**

(57) Un générateur (1) d'impulsions optiques à réflecteur de Bragg distribué est caractérisé en ce que le réflecteur est un réseau (40) réflecteur de Bragg échantillonné, ayant plusieurs pics de réflexion, chaque pic correspondant à une valeur de fréquence optique de réflexion, la différence entre des valeurs consécutives de fréquences de réflexion étant égale à un multiple entier P de la différence entre des valeurs consécutives de fréquences de modes pour lesquelles une cavité optique formée entre une face arrière (13') d'une couche active et un point de réflexion du réflecteur (40) est résonante.

On obtient ainsi des impulsions très courtes avec une faible gigue temporelle.

FIG. 1

Printed by Jouve, 75001 PARIS (FR)

## Description

## Domaine technique

L'invention se situe dans le domaine des générateurs d'impulsions optiques comprenant une partie active laser à l'intérieur d'une cavité résonante délimitée par un premier réflecteur et un second réflecteur qui est un réflecteur de Bragg, la cavité ayant une pluralité de modes résonants, chaque mode résonant correspondant à une fréquence optique de mode.

## Art antérieur

Il existe plusieurs solutions pour créer des impulsions optiques brèves au moyen d'un laser à semi-conducteurs. Ces solutions peuvent être classées en trois catégories.

Une première catégorie de solutions utilise des lasers à semi-conducteurs à commutation de gain.

Cette solution est très utilisée en raison de sa simplicité. Les largeurs des impulsions produites sont de l'ordre de 15 picosecondes. Les impulsions sont fortement modulées en longueur d'onde ("Chirpées").

Une seconde catégorie de solutions utilise des lasers à absorption ou Q-commutés.

Un absorbant saturable est inclus dans la structure du laser. Une modulation externe ou une commutation passive de l'absorption permet d'obtenir des impulsions brèves.

Une troisième catégorie de solutions utilise des lasers à verrouillage de modes.

Cette technique est très répandue. Elle donne actuellement les meilleurs résultats en termes de largeur d'impulsions et en terme de fréquence de répétition. Ainsi il a été obtenu avec des lasers à verrouillage de mode des fréquence de répétition de 40 GHz, voir l'article [1] dont la référence figure en annexe à la présente description. Il a été aussi obtenu des largeurs d'impulsion aussi courtes que 180 femtosecondes, voir l'article [2] dont la référence figure en annexe à la présente description.

Bien que dans des conditions particulières les résultats cités ci-dessus aient pu être obtenus, les lasers à verrouillage de modes sont habituellement utilisés dans des conditions telles que seulement une fraction de la bande de gain du milieu à semi-conducteur est utilisée, typiquement moins de 5 nanomètres alors que la bande utilisable est de l'ordre de 40 à 100 nanomètres. De la sorte on obtient des impulsions relativement larges, en général supérieures à 0,5 picosecondes. De plus la gigue, c'est à dire les dérives temporelles d'une impulsion à l'autre, (jitter) est importante en particulier pour les impulsions les moins larges.

## Brève description de l'invention.

Par rapport à l'art antérieur qui vient d'être décrit, l'invention vise un générateur laser d'impulsions optiques, à semi-conducteurs à verrouillage de modes capable de générer avec une fréquence de répétition stable des impulsions de très courtes durées. L'invention vise à obtenir ce résultat de façon simple et reproductible de façon à limiter les coûts de production.

Selon l'invention il est prévu d'utiliser un laser à semi-conducteurs à verrouillage de modes couplé à un guide d'onde réflecteur à réseau de Bragg échantillonné. On connaît le laser à semi-conducteurs à verrouillage de modes couplé à un guide d'onde réflecteur à réseau réflecteur de Bragg. Dans un tel laser une cavité résonante de Fabry Perot est formé entre une face réfléchissante arrière de la cavité et le réflecteur distribué de Bragg. Selon l'invention au lieu d'utiliser un réseau réflecteur de Bragg simple, on utilise un réseau réflecteur de Bragg échantillonné. De façon en elle même connue un tel réseau est constitué d'une pluralité de sections identiques, constituées chacune par une partie de guide d'onde uniforme sans réseau de Bragg, et d'une partie de guide d'onde uniforme avec réseau de Bragg (appelée échantillon). Il a été démontré qu'un tel réseau génère des pics de réflexion multiples, chaque pic de réflexion correspondant à une valeur de fréquence optique de réflexion (voir l'article [3] dont la référence figure en annexe à la présente description). Si de plus le point de réflexion du guide à réseau échantillonné est positionné de façon à constituer avec la face arrière du laser une cavité dont les dimensions longitudinales induisent des modes résonants de ladite cavité pour lesdites fréquences de réflexion, on émet simultanément sur un large spectre de fréquences et en conséquence il est possible de générer des impulsions optiques de largeur très petite. La période d'échantillonnage du guide échantillonné, c'est à dire la distance entre deux échantillons consécutifs, permet de régler la valeur de la fréquence de répétition des impulsions laser émises par le laser ainsi constitué.

En résumé l'invention est relative à un générateur d'impulsions optiques incluant un milieu actif laser à l'intérieur d'une cavité résonante délimitée entre deux réflecteurs, un premier et un second, la cavité présentant des valeurs de fréquences optiques de modes pour lesquelles la cavité est résonante, le second réflecteur étant constitué par un réflecteur de Bragg, caractérisé en ce que ledit réflecteur de Bragg est constitué par un réseau de Bragg échantillonné présentant plusieurs pics de réflexion, chaque pic correspondant à une valeur de fréquence optique de réflexion, et en ce que la différence entre des valeurs consécutives de fréquences de réflexion est égale à un multiple entier P de la différence entre des valeurs consécutives de fréquence de modes.

Le multiple entier P peut prendre notamment la valeur 1, en sorte que la différence entre des valeurs consécutives de fréquences de réflexion peut aussi être égale à la différence entre des valeurs consécutives de fréquences optiques de mode.

Le multiple entier P peut naturellement prendre toute valeur supérieure ou égale à 1, telle que 1, 2 , 3 et plus. Un choix de valeurs supérieures à 1, comme par exemple 2 ou 3 permet d'utiliser des espacements plus petits des modes résonants de la cavité de Fabryperot et ainsi des longueurs plus grandes du milieu actif. On peut de cette façon obtenir de plus grandes puissances de sortie.

Dans un mode de réalisation, le réseau réflecteur de Bragg présente un pas variable qui diminue en s'éloignant du premier réflecteur.

Le réseau réflecteur de Bragg peut aussi être modulé en profondeur de gravure selon une direction longitudinale du réseau.

Le guide d'onde peut être une fibre optique couplée au milieu actif. Il peut aussi être intégré sur la même puce qu'une partie active de la puce incluant le milieu actif, un milieu de propagation du guide étant situé dans le prolongement du milieu actif formant la couche active de ladite partie active.

Dans un mode de réalisation, une couche guide incluant le milieu actif laser est composée en deux parties une première et une seconde, situées dans le prolongement l'une de l'autre, ces deux parties appartenant respectivement à des première et seconde sections, chacune de ces sections ayant une entrée de commande qui lui est propre.

Dans ce mode de réalisation la première section peut, par exemple être une section de gain. La seconde section peut être par exemple une section d'accord de phase. L'indice effectif de groupe du milieu à semi-conducteurs de ladite seconde section d'accord de phase étant réglable par effet électro-optique par changement d'une valeur d'une grandeur électrique appliquée à ladite seconde section. La seconde section peut aussi être par exemple une section dont le milieu à semi-conducteurs est constitué par une couche d'absorption saturable.

**Brève description des dessins.**

Des modes de réalisation de l'invention seront maintenant décrits en regard des dessins annexés dans lesquels :

La figure 1 est un schéma représentant un mode général de réalisation de l'invention,
La figure 2 représente un réseau échantillonné inscrit sur un guide d'onde ou une fibre .

La figure 3 est composée de trois parties A, B, C, représentant sur une même échelle fréquentielle, en partie A l'espacement des pics de réflexion du réflecteur de Bragg échantillonné, en partie B les valeurs de fréquence correspondant à des modes résonants de la cavité formée entre la face arrière et le réflecteur de Bragg, et en partie C le spectre d'émission des impulsions laser émises par le laser selon l'invention pour P = 1.

La figure 4 représente schématiquement un mode de réalisation d'une partie d'un laser selon l'invention dans lequel une couche guide est incluse dans une première partie qui est une section de gain et dans une seconde partie qui est une section d'accord de phase, les deux parties de guide étant placées dans le prolongement l'une de l'autre.

La figure 5 représente schématiquement un mode de réalisation d'une partie d'un laser selon l'invention dans lequel une couche guide est incluse dans une première partie qui est une section de gain et dans une seconde partie qui est une section d'absorption saturable, les deux parties de guide étant placées dans le prolongement l'une de l'autre.

La figure 6 représente schématiquement un mode de réalisation de l'invention dans lequel le réseau échantillonné est réalisé sur un guide d'onde intégré sur la même puce que la partie active.

La figure 7 représente schématiquement une partie d'un réseau multiplexé en longueur d'onde en lui-même connu utilisant un nombre entier P de générateurs laser selon l'invention.

La figure 8 représente sur un axe fréquentiel les peignes de fréquence d'une parties d'un nombre entier P de lasers selon l'invention utilisés dans un réseau de télécommunication multiplexé en longueur d'onde.

**Description de modes de réalisation**

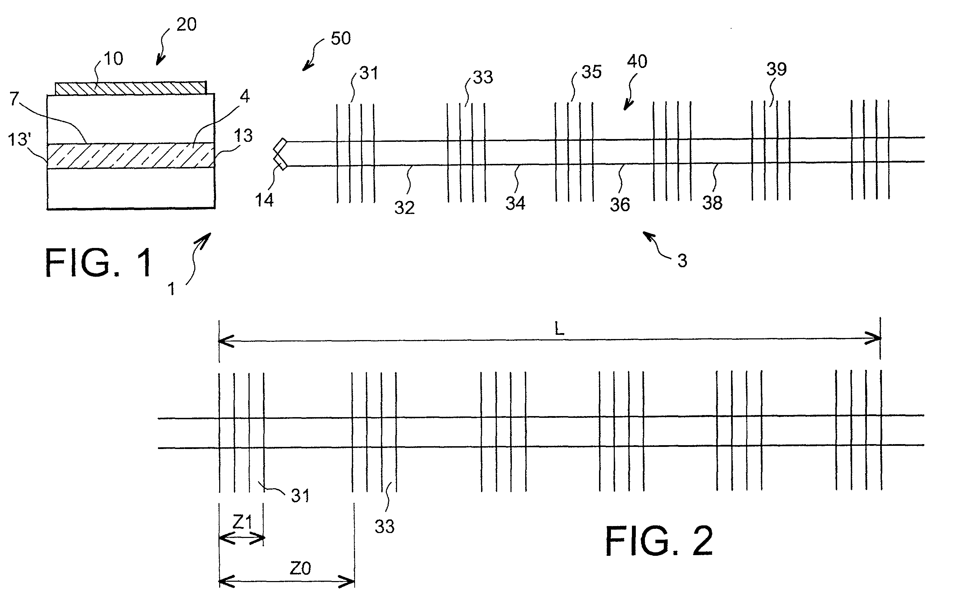

La figure 1 est un schéma représentant un mode général de réalisation d'un laser 1 selon l'invention.

Elle représente une partie active 20 ayant la structure d'un laser à semi-conducteurs, par exemple à ruban superficiel. De façon en elle-même connue la partie active 20 comporte une couche active 4. La couche active 4 est disposée de façon en elle-même connue dans des couches de confinement électrique et optique non référencées sur les figures. Une couche métallique de contact 10, par exemple en AuPt, est située au dessus des couches de confinement pour coopérer avec une électrode inférieure non représentée. Une cavité 50 de Fabry-Perot est formée en deux parties couplées l'une à l'autre. Une première partie 7 de la cavité 50 de Fabry-Perot est constituée par ladite couche active 4. Une face arrière 13' de cette couche est clivée ou traitée pour présenter un fort coefficient de réflexion et ainsi constituer un premier réflecteur de la cavité. Une face avant 13 de cette couche active est traitée pour présenter un coefficient de réflexion aussi faible que possible et si possible nul.

Le matériau de la couche active 4 est choisi pour présenter un gain d'amplification sur une grande largeur de bande et pour être capable de recevoir une modulation directe à haute fréquence, par exemple 10 ou 20 gigahertz ou d'avantage. Un guide d'onde 3, par exemple comme représenté figure 1, une fibre optique, est disposé dans le prolongement longitudinal de la couche active 4. Le guide d'onde 3 est optiquement couplé à la couche laser 4, de préférence dans cet exemple de réalisation, par une lentille de couplage 14.

Pour constituer un second réflecteur de la cavité, un réflecteur de Bragg à réseau distribué échantillonné 40 (SGDBR, Sampled Grating Distributed Bragg Reflector) est gravé dans le guide d'onde 3. Le réflecteur échantillonné 40 (Sampled Grating, SG) est constitué par une alternance d'échantillons de type réseau réflecteur de Bragg distribué, (Distributed Bragg Reflector, DBR) 31, 33,...39 et de sections 32, 34,...38 constituées chacune par une partie de guide d'onde sans échantillon du réseau de Bragg. La face réfléchissante arrière 13' et le réflecteur de Bragg 40 forment ensemble la cavité 50 de Fabry-Perot.

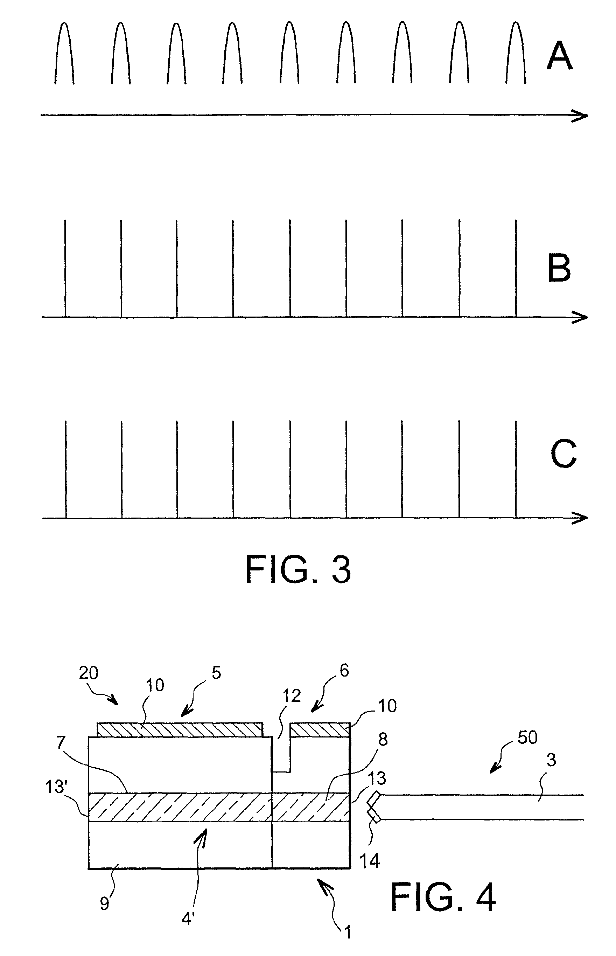

Le mode de fonctionnement du générateur laser 1 selon l'invention tel que représenté figure 1 et des précisions sur le réflecteur de Bragg 40 seront maintenant expliqués et commentés, en liaison avec les figures 2 et 3.

La période Z0 d'échantillonnage représentée figure 2, est définie comme la distance séparant le début de deux zones 31, 33 gravées consécutives. Chaque région gravée a une longueur Z1 et est gravée avec un pas de réseau $\Lambda$. De façon connue, un tel réseau présente des pics de réflexion multiples. L'espacement fréquentiel $\Delta\nu SG$ entre deux pics consécutifs de réflexion est donné par la formule :

$$\Delta\nu SG = c/2n_{gf}Z0 \qquad (1)$$

Dans cette formule :

c est la vitesse de la lumière dans le vide,
$n_{gf}$ est l'indice de groupe de la fibre ou du guide.

La période d'échantillonnage du guide Z0 est choisie pour obtenir un espacement fréquentiel $\Delta\nu SG$ entre deux pics consécutifs de réflexion, correspondant à la fréquence de répétition des impulsions que l'on veut faire générer au laser selon l'invention. Par exemple pour une fréquence de répétition de 40 gigahertz il faudra une période d'environ 2,5 mm dans une fibre en silice ayant un indice de groupe de 1,5.

La longueur d'onde centrale $\lambda_B$ du réseau périodique de Bragg gravé sur chaque zone 31, 33, 35... de longueur Z1 est une fonction de la période de réseau $\Lambda$ et de l'indice n du guide ou de la fibre selon la formule :

$$\lambda_B = 2n\Lambda \qquad (2)$$

Cette longueur d'onde de Bragg correspond à la fréquence moyenne des pics de réflexion du réseau échantillonné.

La largeur spectrale de l'enveloppe du peigne de réflexion formé par l'ensemble des pics de réflexion est déterminée par la longueur Z1 de chacune des zones gravées. La longueur d'onde de Bragg $\lambda_B$, l'espacement fréquentiel $\Delta\nu SG$ entre deux pics consécutifs de réflexion et le nombre de pics de réflexion peuvent ainsi être contrôlés de façon précise en choisissant pour la réalisation du réseau la valeur de paramètres tels que la longueur Z0 des périodes du réseau, la longueur Z1 de chacune des parties gravées, le pas $\Lambda$ de chacune des parties gravées, et la longueur L du réseau échantillonné.

La cavité optique 50 formée entre la face réfléchissante arrière 13' (figure 1) de la couche active 4 et le réflecteur 40 à réseau échantillonné de longueur L, a une longueur égale à la somme de la longueur $L_a$ de la partie active 4 et de la longueur $L_1$ entre l'entrée du guide et le point effectif de réflexion de la lumière. Dans une telle cavité, l'espacement $\Delta\nu FP$ entre deux modes résonants longitudinaux consécutifs est donné par la formule :

$$\Delta\nu FP = c/2 \ (n_aL_a + n_{gf}L_1) \qquad (3)$$

dans laquelle :

$n_a$ et $L_a$ représentent respectivement la valeur de l'indice de groupe et la longueur de la couche active 4 entre ses faces arrière 13' et avant 13,
$L_1$ est la longueur entre l'extrémité du guide ou de la fibre 3 faisant face à la partie active 4, et commençant dans l'exemple commenté en liaison avec la figure 1 à la lentille 14 et le point de cette fibre auquel la lumière réfléchie par la face réfléchissante arrière 13' est effectivement réfléchie par le réflecteur échantillonné 40.

On aura reconnu dans la formule (3) ci-dessus que $(n_aL_a + n_{gf}L_1)$ représente la longueur optique de la cavité optique formée entre la face arrière 13' et le réflecteur 40 de Bragg lorsqu'on néglige la petite distance entre la lentille 14 et la face avant 13 de la partie active 4. Naturellement si cette distance optique n'est pas négligeable, elle devra être prise en compte. La longueur $L_1$ peut être déterminée en mesurant le temps de propagation d'un signal optique dans le réseau échantillonné.

La figure 3 qui sera maintenant commentée est composée de trois parties A, B, C, représentant sur une même échelle fréquentielle, en partie A l'espacement des pics de réflexion du réflecteur de Bragg échantillonné, en partie B les valeurs de fréquence correspondant à des modes résonants de la cavité formée entre la face arrière et le réflecteur de Bragg, et en partie C le spectre d'émission des impulsions laser émises par le laser selon l'invention. Bien entendu, pour permettre le fonctionnement recherché, il convient de dimensionner le réflecteur de sorte que ses pics de réflexion soient suffisamment étroits pour ne pas recouvrir plusieurs fréquences correspondant à des modes résonants. Pour cela, on peut par exemple imposer que la largeur spectrale à mi-hauteur des pics de réflexion soit inférieure à l'intervalle spectral entre deux modes résonants consécutifs.

Dans l'exemple commenté en liaison avec la figure 3, le réseau 40 réflecteur de Bragg échantillonné est gravé sur la fibre 3 en sorte que l'espacement $\Delta\nu SG$ des pics de réflexion donné par la formule (1) ci-dessus soit égal à l'espacement $\Delta\nu FP$ donné par la formule (3) ci-dessus, des modes résonants de la cavité de Fabry Perot formée entre la face arrière 13' de la partie active et le point du guide d'onde 3 où la lumière est effectivement réfléchie . Ce fait est représenté figure 3 parties A et B où l'on voit que les pics de réflexion du guide 3 représenté en A et les modes résonants de la cavité représentés en B se situent les uns sous les autres, montrant ainsi que ces pics et ces modes résonants correspondent à des même valeurs de fréquence. Le cas représenté figure 3 correspond au cas où P est égal à 1. Dans ce cas les composantes du spectre d'émission du laser 1 se situe également aux mêmes fréquences comme représenté en partie C.

Comme expliqué plus haut, la fibre 3 peut aussi être gravée en sorte que l'espacement $\Delta\nu SG$ des pics de réflexion donné par la formule (1) ci-dessus soit égal à un autre multiple entier de l'espacement $\Delta\nu FP$ donné par la formule (3) ci-dessus. Dans ce cas pour une même cavité l'espacement des modes sera tel que représenté en partie B. Par contre si l'on prend par exemple P = 2, un pic sur deux ne figure plus en partie A, les fréquences correspondant aux modes résonants de la cavité 50 représentés en partie B ne changent pas puisqu'ils ne dépendent que de la longueur optique de la cavité, une fréquence sur deux en partie C est supprimée, car le mode correspondant n'est pas excité.

En fonctionnement, il convient de pouvoir assurer que les fréquences des pics de réflexion coïncident avec des fréquences de modes résonants. Ceci peut être réalisé par un simple asservissement de la température de la partie 20 comportant la couche active 4. On peut aussi agir sur une section de phase si une telle section est prévue, comme dans une variante de réalisation exposée ci-dessous.

Si l'on provoque une modulation, par exemple en amplitude ou en fréquence optique de l'onde laser, avec une fréquence de modulation $f_m$ telle que

$$f_m = \Delta\nu SG = P\Delta\nu FP, \qquad (4)$$

on obtient le verrouillage de modes, ce qui signifie que les modes excités seront synchronisés en phase. Le nombre des modes résonants excités de la cavité de Fabry-Perot est égal au nombre de pics de réflexion du réflecteur 40 de Bragg échantillonné, ceci à condition que la courbe de gain du milieu actif ait une largeur de bande à mi hauteur supérieure à celle de l'enveloppe de la courbe de réflexion du réseau échantillonné. Plus le nombre de pics sera important et plus la largeur des impulsions produites pourra être petite. A titre d'exemple si la longueur de la cavité de Fabry-Perot et le réflecteur 40 sont conçus pour avoir une même valeur d'espacement de 40 gigahertz entre modes résonants de la cavité et entre pics consécutifs, et s'il y a 10 pics de réflexion, la largeur de bande $\Delta\nu$ du signal émis est de 400 gigahertz. Une transformée de Fourier de ce signal de l'espace fréquentiel à l'espace temporel conduit dans ces conditions à une largeur d'impulsion $\Delta t$ du signal de

$$\Delta t = 0,43/\Delta\nu = 1 \text{ picoseconde}$$

On voit ainsi que la seule limite à la brièveté des impulsions provient de la dynamique de gain inter bande dans le matériau semi-conducteur constituant la couche active 4.

Avec une telle configuration les fluctuations de la fréquence de répétition sont réduites car l'espacement des pics du peigne de réflexion du réflecteur segmenté peut être très bien contrôlé et la largeur spectrale de chaque pic peut être très étroite.

Des variantes de réalisation du réseau échantillonné seront maintenant décrites.

Le réseau de chacun des échantillons peut avoir un pas variable (chirped). Il peut aussi être apodisé, par une modulation appropriée de la profondeur de la gravure selon la direction longitudinale du réseau. Lorsque le réseau est à pas variable, le pas peut varier de façon linéaire ou non avec la distance longitudinale par rapport à un point fixe du guide, ce pas diminuant en s'éloignant dudit premier réflecteur. L'avantage d'un tel réseau de pas variable, est comme expliqué dans l'article [4] dont la référence figure en annexe à la présente description, que l'on accroît la stabilité modale. Lorsque le réseau est apodisé le coefficient de couplage entre l'onde aller et l'onde retour de chaque période peut varier de façon à éliminer des pics latéraux de réflexion dans la courbe donnant la valeur de la réflexion en fonction de la fréquence optique.

Enfin selon une autre variante de réalisation une modulation sous-harmonique peut être appliquée. Dans ce cas la région active ou comme il sera décrit plus loin, une section de modulation de phase de cette région est modulée avec une fréquence dont la valeur est un quotient par un nombre entier de la différence entre fréquences de modes correspondant à des modes résonants excités de la cavité de Fabry-Perot 50. On réduit ainsi la contrainte sur le besoin en électronique de haute fréquence ainsi que sur la bande passante de modulation de la puce.

Des variantes de réalisation de la partie active 20 seront maintenant commentées en liaison avec les figures 4-6. Dans ces figures les éléments ayant même fonction que ceux commentés en liaison avec la figure 1 portent le même numéro de référence. Ces éléments ayant même fonction ne seront pas nécessairement commentés à nouveau.

La figure 4 représente un mode de réalisation dans lequel une couche guide à semi-conducteurs 4' incluant le milieu actif est formée en deux parties couplées 7, 8 situées dans le prolongement l'une de l'autre. La première partie 7 de la couche guide 4' est une partie à gain, par exemple à puits quantiques multiples formée par une première épitaxie. La seconde partie 8 de la couche guide 4' est une partie guide d'onde présentant un effet électro-optique, par exemple de Franz-Keldysh, formée par une seconde épitaxie sélective. Chacune des parties 7, 8 de la couche guide est intégrée sur un substrat unique 9 en InP. La partie 20 du laser est formée dans ce cas en deux sections 5, 6 sur le substrat unique 9. Les deux sections diffèrent l'une de l'autre par la nature de la couche guide 4'. La première partie 7 de la couche guide 4' constitue la couche active de la première section 5. La seconde partie 8 de la couche guide 4' est incluse dans la seconde section 6. Les deux parties 7, 8 de couche guide sont disposées de façon en elle-même connue dans des couches de confinement électrique et optique non référencées sur les figures. Une couche métallique de contact 10 par exemple en AuPt est située au dessus des couches de confinement. Les deux sections 5, 6 sont séparées l'une de l'autre par une gravure 12 effectuée dans la couche de contact 10 et dans une partie des couches de confinement situées au-dessus de la couche guide 4'. Il en résulte que les deux sections 5, 6 peuvent recevoir chacune une commande propre, par exemple sous forme d'un courant injecté dans la première section 5 et sous forme d'une tension appliquée à la seconde section 6. On peut ainsi changer la longueur optique du guide d'onde 4', par une commande de tension appliquée à la seconde section 6, sans influence notable sur la puissance émise par le laser.

Ainsi on sépare la fonction de gain dévolue à la section 5 et la fonction d'accord de phase dévolue à la section 6. On peut ainsi obtenir de façon relativement facile un accord excellent entre l'espacement des pics de réflexion qui résulte de la réalisation du réseau de Bragg sur le guide et l'espacement des modes résonants de la cavité 50 de Fabry-Perot qui dépend de la longueur optique de la cavité 50 que l'on peut faire varier de façon indépendante par action sur une valeur de commande de la section 6. La commande de cette section 6 peut aussi être utilisée comme commande de modulation pour produire une modulation de fréquence par modulation d'indice optique à la fréquence $f_m$. Dans ce cas, le laser est verrouillé par la modulation de fréquence. Grâce à la modulation de fréquence à la fréquence $f_m$, chaque composante fréquentielle est en phase avec les autres composantes fréquentielles (Frequency modulation mode-locked).

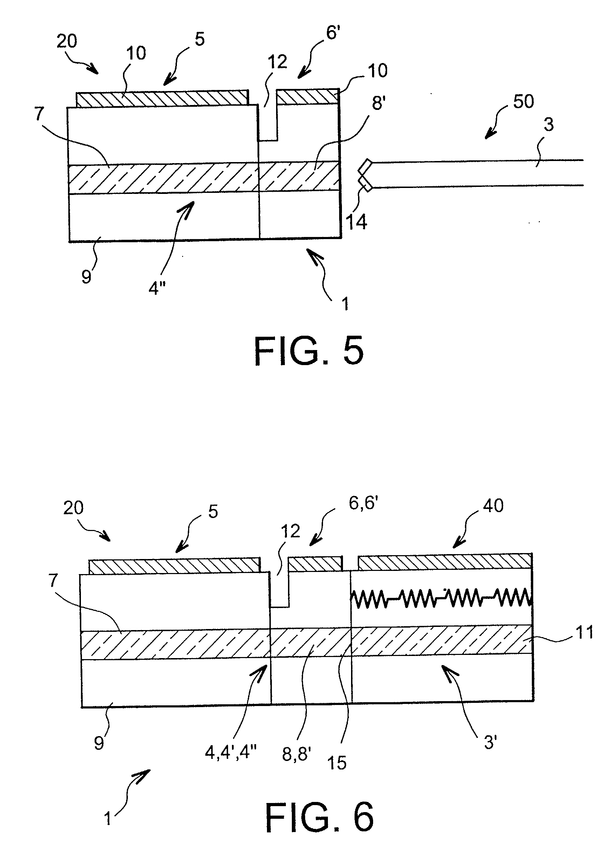

Selon un autre mode de réalisation qui sera maintenant commenté en liaison avec la figure 5, la partie active 20 est formée comme dans le cas précédent décrit en liaison avec la figure 4 formée en deux sections 5, 6'. La première partie 7 de couche guide 4" de la première section 5 est comme dans le cas précédent une couche de gain par exemple à puits quantiques. La seconde partie 8' de couche guide 4" de la seconde section 6' est une couche d'absorption saturable. Cette seconde partie 8' de la couche guide peut être par exemple à puits quantiques ou à matériau massif (bulk). La polarisation de la section 6' d'absorption est comme dans le cas précédent indépendante de la polarisation de la section 5 de gain. La polarisation de la section 6' d'absorption peut être soit une tension négative appliquée à la jonction n/p entre la couche guide 8' et une couche de confinement électrique, soit un faible courant. La seconde partie 8' de couche guide 4" peut être enrichie en ions pour diminuer la durée de vie des porteurs.

La configuration décrite en liaison avec la figure 5 permet un verrouillage passif de modes par commutation passive de la section 6' d'absorption.

Ce mode de fonctionnement permet en particulier une récupération tout optique d'horloge. Dans ce mode de fonctionnement les impulsions produites par la commutation des pertes sont synchronisées en fréquence et en phase à celles du signal injecté.

Un mode de réalisation dans lequel le guide 3' d'onde portant le réflecteur 40 de Bragg échantillonné est formé dans un guide intégré à la puce portant la partie active 20 sera maintenant décrit en liaison avec la figure 6.

Pour des facilités de fabrication il est préférable de réaliser le réseau échantillonné sur une fibre ou sur un guide d'onde en silice ou en polymère comme représenté figures 1, 4 ou 5. Dans le cas de la fibre ou du guide d'onde en silice ou en polymère les échantillons de réseaux de Bragg 31, 33 peuvent être réalisés par insolation directe. En particulier dans le cas des fibres ou guides en silice, en plus des avantages bien connus de ces guides, faibles pertes, technologies bien maîtrisées, fiabilité, il est à noter que l'indice de réfraction de ces guides peut être ajusté de façon continue par une procédure d'illumination uniforme du guide. Cet ajustement de la valeur de l'indice de réfraction permet un réglage fin de l'espacement des pics de réflectivité $\Delta vSG$.

Le réseau échantillonné peut aussi comme représenté figure 6, être gravé sur un guide d'onde intégré en InP. Dans ce cas comme représenté sur cette figure la partie guide d'onde 3' est formée sur la puce portant la partie active 20, dans une couche guide 11 ayant une extrémité 15 abutée à la couche guide 4 de la partie 20. La partie 20 peut être réalisée selon l'un quelconque des modes commentés en liaison avec la figure 1 ou avec les figures 4 ou 5 comme représenté figure 6. On note cependant que dans ce mode de réalisation on est actuellement limité à des lasers fonctionnant à de très hautes fréquences de répétition, par exemple supérieures à 80 gigahertz, ceci en raison de la longueur limitée que l'on peut actuellement obtenir avec de tels guides sur semi-conducteurs.

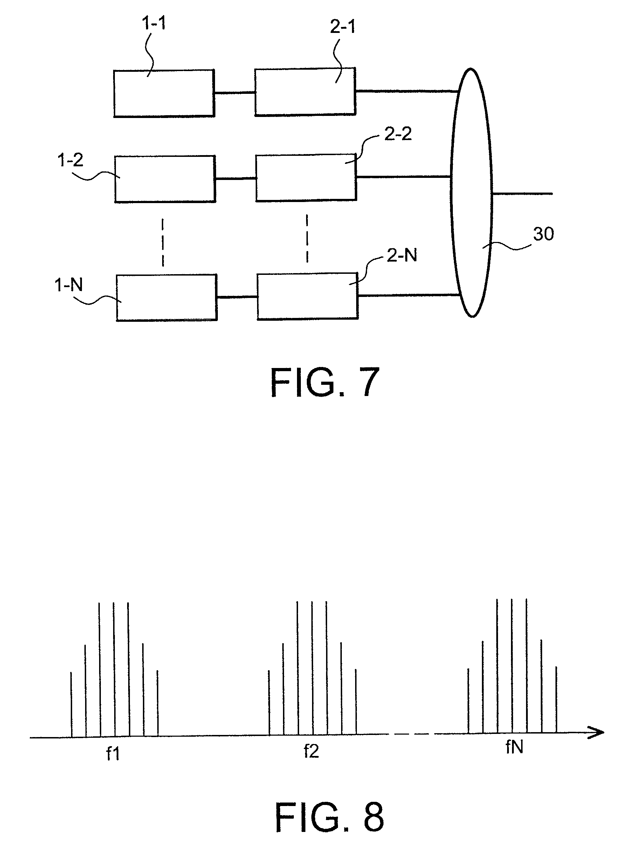

Des lasers selon l'invention peuvent de façon avantageuse être utilisés pour la réalisation de télécommunications multiplexées en longueur d'onde. (WDM). Dans ce cas la fréquence centrale de réseau du réflecteur échantillonné affecté à chaque laser et l'enveloppe des pics de réflexion du réflecteur sera choisie de façon à ce qu'il n'y ait pas de chevauchement entre les peignes de réflexion des différents lasers. On a représenté en figure 7 un tel réseau multiplexé, en lui-même connu composé de N - N désignant un nombre entier - générateurs laser 1 selon l'invention références 1-1 à 1-N. Chacun des générateurs 1 est couplé à un modulateur 2. Lesdits modulateurs 2 sont référencés 2-1 à 2-N. Les N modulateurs sont couplés à un multiplexeur 30. On a représenté en figure 8, sur un axe fréquentiel les différents spectres de réflexion d'un premier laser selon l'invention dont la fréquence centrale de réseau est calée sur une première fréquence f1, et celle d'un deuxième et d'un Nième laser ayant respectivement pour fréquence centrale de réseau f2, fN. Les différentes fréquences centrales f1, f2, fN correspondent aux fréquences de la grille ITU.

**Annexe**

**liste de documents pertinents de l'art antérieur.**

[1] D. Arbel,U. Koren, S. Shalom, M. Winik, L. Reznik, M. Zimmermann, R. Sasson, D. Hadas, S. Breitbar, 27 ème conférence sur les communications optiques, 30 septembre-4 octobre 2001 ; Netherland, Texte de la conférence non encore publié.

[2] R.Ludwig, S.Diez et al, IEICE Trans. Electron., vol E81-C, n° 2, Pages 140-145, 1998.

[3] V. Jayaraman, Z-M. Chuang et L. A. Goldren, IEEE Journal of Quantum Electronics, vol. 29, n° 6, pages 1824-1834, 1993.

[4] A. Morton, V. Mizrahi, et al Applied Physics Letters, Vol. 64, Pages 2634-2636, 1994.

**Revendications**

1. Générateur (1) d'impulsions optiques incluant un milieu (4, 7) actif laser à l'intérieur d'une cavité résonante (50) délimitée entre deux réflecteurs (13', 40), un premier (13') et un second (40), la cavité (50) présentant des valeurs de fréquences optiques de modes pour lesquelles la cavité est résonante, le second réflecteur (40) étant constitué par un réflecteur de Bragg, **caractérisé en ce que** ledit réflecteur (40) de Bragg est constitué par un réseau de Bragg échantillonné (31-39) présentant plusieurs pics de réflexion, chaque pic correspondant à une valeur de fréquence optique de réflexion, et **en ce que** la différence entre des valeurs consécutives de fréquences de réflexion est égale à un multiple entier P de la différence entre des valeurs consécutives de fréquence de modes.

2. Générateur (1) d'impulsions optiques selon la revendication 1, **caractérisé en ce que** le réseau (40) réflecteur de Bragg présente un pas variable qui diminue en s'éloignant dudit premier réflecteur (13').

3. Générateur (1) d'impulsions optiques selon la revendication 1 ou 2, **caractérisé en ce que** le réseau (40) réflecteur de Bragg est modulé en profondeur de gravure selon une direction longitudinale du réseau (40).

4. Générateur (1) d'impulsions optiques selon l'une des revendications 1 à 3, **caractérisé en ce que** le guide d'onde est une fibre optique (3) couplée au milieu actif laser (4).

5. Générateur (1) d'impulsions optiques selon l'une des revendications 1 à 3, **caractérisé en ce que** le guide d'onde (3') est intégré sur une puce incluant le milieu actif laser (4), un milieu (8) de propagation du guide étant situé dans le prolongement dudit milieu actif (4).

6. Générateur (1) d'impulsions optiques selon l'une des revendications 1 à 5, **caractérisé en ce qu'**une couche guide (4') incluant le milieu (7) actif laser est composée en deux parties, une première (7) et une seconde (8) situées dans le prolongement l'une de l'autre, ces deux parties (7, 8) appartenant respectivement à des première et seconde sections (5, 6, 6'), chacune de ces sections (5, 6, 6') ayant une entrée de commande qui lui est propre.

7. Générateur (1) d'impulsions optiques selon la revendication 6, **caractérisé en ce que** la première section (5) est une section de gain, et **en ce que** la seconde section (6) est une section d'accord de phase, l'indice effectif de groupe de ladite seconde partie (8) de la couche guide incluse dans la section d'accord de phase (6) étant réglable par effet électro-optique par changement d'une valeur d'une grandeur électrique appliquée à ladite seconde section (6).

8. Générateur (1) d'impulsions optiques selon la revendication 6, **caractérisé en ce que** la première section (5) est une section de gain, et **en ce que** la seconde partie (8') de la couche guide (4") incluse dans la seconde section (6') est une couche d'absorption saturable.

9. Système de télécommunication optique multiplexé en longueur d'onde, **caractérisé en ce qu'**il comprend des générateurs (1-1,...,1-N) d'impulsions optiques selon la revendication 7.

10. Dispositif tout optique de récupération d'un signal d'horloge, **caractérisé en ce qu'**il comprend un générateur (1) d'impulsions optiques selon la revendication 8.

**FIG. 1**

**FIG. 2**

A

B

C

FIG. 3

FIG. 4

**FIG. 5**

**FIG. 6**

FIG. 7

FIG. 8

**Office européen des brevets**

# RAPPORT DE RECHERCHE EUROPEENNE

Numéro de la demande

EP 02 29 2524

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int.Cl.7) |
|---|---|---|---|
| X | KIM B-S ET AL: "DYNAMIC ANALYSIS OF MODE-LOCKED SAMPLED-GRATING DISTRIBUTED BRAGG REFLECTOR LASER DIODES" IEEE JOURNAL OF QUANTUM ELECTRONICS, IEEE INC. NEW YORK, US, vol. 35, no. 11, novembre 1999 (1999-11), pages 1623-1628, XP000902529 ISSN: 0018-9197 * page 1626, colonne de droite, ligne 1-10; figures 1,2 * | 1,5,6, 8-10 | H01S5/14 H01S5/125 H01S5/0625 H01S5/065 |
| A | YU J ET AL: "Fourier-transform-limited 2.5 ps light pulses with electrically tunable wavelength (15 nm) by hybridly modelocking a semiconductor laser in a chirped Bragg grating fibre external cavity" ELECTRONICS LETTERS, IEE STEVENAGE, GB, vol. 31, no. 23, 9 novembre 1995 (1995-11-09), pages 2008-2009, XP006003602 ISSN: 0013-5194 * figure 1 * | 1,2,4 | |
| A | EP 0 949 729 A (CSELT CENTRO STUDI LAB TELECOM) 13 octobre 1999 (1999-10-13) * figure 2 * | 1,3 | |
| A | WO 00 22705 A (ACREO AB ;RIGOLE PIERRE JEAN (SE)) 20 avril 2000 (2000-04-20) * figure 7 * | 1,4,6,7 | |

DOMAINES TECHNIQUES RECHERCHES (Int.Cl.7)

H01S

Le présent rapport a été établi pour toutes les revendications

| Lieu de la recherche | Date d'achèvement de la recherche | Examinateur |
|---|---|---|
| LA HAYE | 24 février 2003 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)

**ANNEXE AU RAPPORT DE RECHERCHE EUROPEENNE
RELATIF A LA DEMANDE DE BREVET EUROPEEN NO.**

EP 02 29 2524

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-02-2003

| Document brevet cité au rapport de recherche | | Date de publication | Membre(s) de la famille de brevet(s) | | Date de publication |
|---|---|---|---|---|---|
| EP 0949729 | A | 13-10-1999 | IT | T0980306 A1 | 11-10-1999 |
| | | | EP | 0949729 A2 | 13-10-1999 |
| | | | JP | 3023552 B2 | 21-03-2000 |
| | | | JP | 2000022245 A | 21-01-2000 |
| | | | US | 6226311 B1 | 01-05-2001 |
| WO 0022705 | A | 20-04-2000 | AT | 230170 T | 15-01-2003 |
| | | | AU | 1194200 A | 01-05-2000 |
| | | | CA | 2344536 A1 | 20-04-2000 |
| | | | CN | 1324505 T | 28-11-2001 |
| | | | DE | 69904624 D1 | 30-01-2003 |
| | | | EP | 1118145 A1 | 25-07-2001 |
| | | | JP | 2002527911 T | 27-08-2002 |
| | | | SE | 9803285 A | 29-03-2000 |
| | | | WO | 0022705 A1 | 20-04-2000 |

EPO FORM P0460

Pour tout renseignement concernant cette annexe : voir Journal Officiel de l'Office européen des brevets, No. 12/82